# DEMANDE DE BREVET EUROPEEN

(11) **EP 4 391 068 A1**
(43) Date de publication de la demande: **26.06.2024**
(21) Numéro de dépôt: 23218293.1
(22) Date de dépôt: 19.12.2023
(51) Int. Cl.: H01L 29/06, H01L 29/423, H01L 29/66, B82Y 10/00

(54) **DISPOSITIF QUANTIQUE DESTINÉ À FORMER UNE MATRICE DE BOITES QUANTIQUES ET PROCÉDÉ DE FABRICATION ASSOCIÉ**

(30) Priorité: 20.12.2022 FR 2213999
(71) Demandeur: Commissariat à l'énergie atomique et aux énergies alternatives, 75015 Paris (FR)
(72) Inventeur: BERTRAND, Benoit, 38054 GRENOBLE CEDEX 09 (FR); BEDECARRATS, Thomas, 38054 GRENOBLE CEDEX 09 (FR); NIEBOJEWSKI, Heimanu, 38054 GRENOBLE CEDEX 09 (FR)
(74) Mandataire: Cabinet Camus Lebkiri

(57) **Abrégé**

Un aspect de l'invention concerne une dispositif quantique (DO) configuré pour pouvoir former une matrice de boites quantiques (OD), le dispositif (DO) comprenant pour cela : une couche active (CA) réalisée dans un matériau semi-conducteur ; une pluralité de premières grilles (G1) disposées selon une pluralité de lignes (LI) ; une pluralité de deuxièmes grilles (G2) disposées selon un pluralité de colonnes (CO) perpendiculaires aux lignes (LI) de la pluralité de lignes (LI) ; une pluralité de troisièmes grilles (G3), chaque troisième grille (G3) de la pluralité de troisièmes grilles (G3) étant disposée à l'intersection d'une ligne de la pluralité de lignes (LI) et d'une colonne de la pluralité de colonnes (CO), chaque troisième grille (G3) étant séparée des troisièmes grilles (G3) les plus proches, sur une ligne (LI) par une première grille (G1) et sur une colonne (CO) par une deuxième grilles (G2) ; la couche active (CA) comprenant des ouvertures (OU), remplies d'un matériau diélectrique, sur toute l'épaisseur de la couche active (CA) disposées entre les lignes (LI) de la pluralité de lignes (LI) et les colonnes (CO) de la pluralité de colonnes (CO).

## Description

### DOMAINE TECHNIQUE DE L'INVENTION

Le domaine technique de l'invention est celui de l'informatique quantique.

La présente invention concerne un dispositif semi-conducteur comprenant des moyens pour former une matrice de boites quantiques et en particulier un dispositif permettant de contrôler le potentiel chimique au sein de chaque boite quantique et le couplage entre des boites quantiques adjacentes, ce contrôle se faisant de manière locale, tout en garantissant l'absence de particule chargée en dehors des boites quantiques. La présente invention concerne également un procédé de fabrication permettant d'obtenir un tel dispositif.

### ARRIÈRE-PLAN TECHNOLOGIQUE DE L'INVENTION

Dans le domaine de l'informatique quantique, il est connu d'utiliser des boites quantiques dans lesquelles une ou plusieurs particules chargées peuvent être piégées pour être manipulées. Pour cela, le confinement des particules chargées doit se faire dans les trois dimensions de l'espace. Dans l'état de la technique, un tel confinement peut être obtenu de deux manières (qui peuvent être utilisées en combinaison) : de manière structurelle (par alternance de matériaux selon au moins une dimension de l'espace) et/ou de manière électrostatique par l'application d'un potentiel sur une portion de matériau conducteur (par exemple à l'aide d'une électrode de grille). De manière générale, les boites quantiques sont agencées sous la forme d'une matrice de boites quantiques ce qui permet une meilleure inter-connectivité entre boites quantiques et donc, par exemple, une exécution plus efficace des algorithmes de correction d'erreurs quantiques (voir par exemple Fowler, Phys. Rev. A, 2012).

Une matrice de boites quantiques a par exemple été proposée dans le document Li et al., Science, 2018. Dans ce document, les auteurs proposent une structure comprenant trois niveaux de grilles : selon les lignes, les colonnes et les diagonales de la matrice de boites quantiques, ces niveaux de grille permettant de contrôler le potentiel chimique dans chaque boite quantique ainsi que les barrières de potentiel (ou couplage tunnel) entre les boites quantiques adjacentes. En revanche, le dispositif ne permet pas de contrôler totalement la position des particules chargées et, en particulier, d'interdire la présence de ces dernières en dehors des boites quantiques, c'est à dire entre les lignes et les colonnes de la matrice de boites quantiques. De plus, l'utilisation de trois niveaux de grilles implique un écrantage des niveaux de grille supérieurs par les niveaux de grille inférieurs ce qui entraîne une forte disparité entre les différents niveaux de grille (la grille de premier niveau apparaît continue alors que les grilles de deuxième et troisième niveau prennent la forme d'une ligne pointillée).

Une autre architecture a été proposée dans le document FR3066297. Dans cette dernière, la couche active de la matrice de boites quantiques est structurée de sorte à interdire la présence de particules chargées en dehors des boites quantiques, c'est à dire entre les lignes et les colonnes de la matrice de boites quantiques. Par ailleurs, le dispositif proposé comprend également une pluralité de grilles permettant de contrôler les barrières de potentiel entre les boites quantiques adjacentes de la matrice de boites quantiques. En revanche, compte tenu de la difficulté d'implantation, le dispositif proposé ne comprend pas de grille permettant un contrôle local du potentiel chimique au sein de chaque boite quantique. En outre, le contrôle des grilles est réalisé à l'aide de vias ce qui permet une bonne homogénéité entre les grilles, mais impose en revanche des contraintes très strictes en termes d'alignement relatif des différents niveaux de grilles, et rendant donc le procédé de fabrication complexe à mettre en oeuvre.

Il existe donc un besoin d'un dispositif permettant d'obtenir à la fois un contrôle électrostatique homogène, un contrôle local (c'est à dire par une grille située au-dessus de l'élément à contrôler) du potentiel chimique au sein de chaque boite quantique et un moyen de garantir l'absence de charge électrique entre les lignes et les colonnes de la matrice. Il existe en outre un besoin d'un procédé permettant d'obtenir un tel dispositif sans imposer des contraintes très strictes d'alignement lors de la fabrication.

### RÉSUMÉ DE L'INVENTION

L'invention offre une solution aux problèmes évoqués précédemment, en proposant un dispositif permettent d'obtenir à la fois un contrôle électrostatique homogène, le contrôle local (c'est à dire par une grille située directement au-dessus de l'élément à contrôler) du potentiel chimique au sein de chaque boite quantique et un moyen de garantir l'absence de particule chargée entre les lignes et les colonnes de la matrice. Elle y parvient grâce notamment à la mise en oeuvre d'un procédé permettant de réaliser les grilles ainsi que les motifs entre les lignes et les colonnes de la matrice de boites quantiques de manière auto-alignée et sur un seul niveau de lithographie.

Pour cela, un premier aspect de l'invention concerne un dispositif quantique configuré pour former une matrice de boites quantiques, le dispositif comprenant :
- Une couche active réalisée dans un matériau semi-conducteur ;
- Une pluralité de premières grilles disposées selon une pluralité de lignes ;
- Une pluralité de deuxièmes grilles disposées selon une pluralité de colonnes perpendiculaires aux lignes de la pluralité de lignes ;
- Une pluralité de troisièmes grilles, chaque troisième grille de la pluralité de troisièmes grilles étant disposée à l'intersection d'une ligne de la pluralité de lignes et d'une colonne de la pluralité de colonnes, chaque troisième grille étant séparée des troisièmes grilles les plus proches, sur une ligne par une première grille et sur une colonne par une deuxième grille ;
la couche active comprenant des ouvertures sur toute l'épaisseur de la couche active disposées entre les lignes de la pluralité de lignes et les colonnes de la pluralité de colonnes.

Avantageusement, chaque première grille de la pluralité de premières grilles s'étend entièrement sur la couche active et chaque deuxième grille de la pluralité de deuxièmes grilles s'étend entièrement sur la couche active.

Grâce au dispositif selon l'invention, il est possible d'obtenir un dispositif permettant un contrôle électrostatique homogène, un contrôle local (par une grille située directement au-dessus de l'élément à contrôler) du potentiel chimique au sein de chaque boite quantique et un moyen de garantir l'absence de charge électrique entre les lignes et les colonnes de la matrice. Plus particulièrement, dans le dispositif selon l'invention, une boite quantique pourra être formée au-dessous de chaque troisième grille de sorte à former une matrice de boites quantiques. En effet, chaque première grille de la pluralité de premières grilles permet, lorsqu'on lui applique un potentiel électrique, de modifier la barrière de potentiel séparant deux parties de la couche active situées sous deux troisièmes grilles adjacentes selon les lignes. De même, chaque deuxième grille de la pluralité de deuxièmes grilles permet, lorsqu'on lui applique un potentiel électrique, de modifier la barrière de potentiel séparant deux parties de la couche active situées sous deux troisièmes grilles adjacentes selon les colonnes. De plus, les premières grilles et les deuxièmes grilles permettent d'effectuer cette modification de manière locale, ces dernières n'étant pas « écrantée » par une couche conductrice (autrement dit, il n'y a pas de couche conductrice entre l'oxyde des premières grilles et des deuxièmes grilles et la couche active). Aussi, grâce au contrôle des barrières de potentiel exercé par les premières grilles et les deuxièmes grilles, il est possible de réaliser un confinement électrostatique des particules chargées au-dessous des troisièmes grilles de la pluralité de troisièmes grilles pour former une boite quantique sous chaque troisième grille. Ce confinement électrostatique est en outre complété par un confinement structurel obtenu grâce aux ouvertures présentes dans la couche active, puisqu'aucune particule chargée ne peut se trouver au niveau desdites ouvertures.

Par ailleurs, dans chaque boite quantique, le ou les particules chargées présentes sont associées à un potentiel chimique. Or, chaque troisième grille n'étant pas « écrantée » par une couche conductrice (autrement dit, il n'y a pas de couche conductrice entre l'oxyde des troisièmes grilles et la couche active), chaque troisième grille de la pluralité de troisièmes grilles permet, lorsqu'on lui applique un potentiel électrique, de modifier le potentiel chimique des particules chargées présentes dans boite quantique associée à la troisième grille considérée.

Outre les caractéristiques qui viennent d'être évoquées dans le paragraphe précédent, le dispositif selon le premier aspect de l'invention peut présenter une ou plusieurs caractéristiques complémentaires parmi les suivantes, considérées individuellement ou selon toutes les combinaisons techniquement possibles.

Dans un mode de réalisation, chaque troisième grille de la pluralité de troisièmes grilles s'étend entièrement sur la couche active.

Dans un mode de réalisation, chaque grille des pluralités de premières, deuxièmes, troisièmes et quatrièmes grilles, s'étend sur une première dimension, dite première largeur, mesurée selon une ligne ou une colonne, la couche active présentant une deuxième dimension, dite deuxième largeur, mesurée selon ladite ligne ou ladite colonne, supérieure ou égale à la première largeur.

Dans un mode de réalisation, chaque première grille et chaque deuxième grille présente une longueur et une épaisseur strictement inférieure à la longueur. La longueur est préférentiellement mesurée parallèlement à la couche active et l'épaisseur est préférentiellement mesurée perpendiculairement à la couche active.

Dans un mode de réalisation, chaque première grille présente une longueur et une largeur, inférieure ou égale à la longueur, chaque première grille étant disposée de sorte que sa longueur soit alignée avec une ligne de la pluralité de lignes. Préférentiellement, chaque deuxième grille présente une longueur et une largeur, inférieure ou égale à la longueur, chaque deuxième grille étant disposée de sorte que sa longueur soit alignée avec une colonne de la pluralité de colonne.

Dans un mode de réalisation, chaque troisième grille présente une forme d'étoile à quatre branches dont une première diagonale, passant par deux branches opposées, est parallèle à une ligne de la pluralité de lignes, et dont une deuxième diagonale, distincte de la première diagonale et passant par deux autres branches opposées, est parallèle à une colonne de la pluralité de colonne.

Dans un mode de réalisation, chaque première grille présente une forme rectangulaire dont une troisième diagonale, passant par deux sommets opposés, présente un angle avec une ligne de la pluralité de lignes, inférieur ou égal à 45° ; chaque deuxième grille présente également une forme rectangulaire dont une quatrième diagonale, passant par deux sommets opposés, présente un angle avec une colonne de la pluralité de colonnes, inférieur ou égale à 45°.

Dans un mode de réalisation, les premières, deuxièmes et troisièmes grilles sont disposées à une même distance de la couche active.

Dans un mode de réalisation, le dispositif comprend une première couche diélectrique s'étendant sur la couche active, chaque première grille, chaque deuxième grille et chaque troisième grille s'étendant sur la première couche diélectrique. La première couche diélectrique est préférentiellement commune à toutes les grilles.

Dans un mode de réalisation, la pluralité de premières grilles est polarisable indépendamment de la pluralité de troisièmes grilles.

Dans un mode de réalisation, la pluralité de deuxièmes grilles est polarisable indépendamment de la pluralité de troisièmes grilles.

Dans un mode de réalisation, chaque pluralité de grilles parmi les pluralités de premières, deuxièmes et troisièmes grilles, est polarisable indépendamment des autres pluralités de grilles parmi les pluralités de premières, deuxièmes et troisièmes grilles.

Dans un mode de réalisation, chaque grille parmi les premières, deuxièmes et troisièmes grilles est polarisable indépendamment des autres grilles parmi les premières, deuxièmes et troisièmes grilles.

Par « grille polarisable indépendamment des autres grilles », on entend qu'il est possible est possible d'appliquer un potentiel électrique sur ladite grille sans appliquer ledit potentiel sur les autres grilles.

Par « pluralité de premières grilles polarisables indépendamment d'une autre pluralité de grilles », on entend qu'il est possible est possible d'appliquer un potentiel électrique sur chacune des premières grilles, sur un sous-ensemble de premières grilles, ou sur toutes les premières grilles, sans appliquer ledit potentiel sur aucune autre grille des autres pluralités de grilles.

Dans un mode de réalisation, chaque première grille est polarisable indépendamment des autres premières grilles et des deuxièmes et troisièmes grilles ; et chaque deuxième grille est polarisable indépendamment des autres deuxièmes grilles et des premières et troisièmes grilles ; et chaque troisième grille est polarisable indépendamment des autres troisièmes grilles et des premières et deuxièmes grilles.

Dans un mode de réalisation, le dispositif est réalisé à partir d'un substrat de type « silicium sur isolant » (ou SOI pour Silicon On Insulator en anglais), la couche active étant réalisée dans la couche de silicium du substrat située au-dessus de l'oxyde.

Dans un mode de réalisation, le dispositif est réalisé à partir d'un substrat de silicium massif. Avantageusement, le substrat comprend une couche de silicium epitaxiée recouverte d'un oxyde thermique. Dans ce mode de réalisation, la couche active étant réalisée dans la couche de silicium, de préférence epitaxiée.

Dans un mode de réalisation, le dispositif est réalisé à partir d'une hétérostructure Si/SiGe, la couche active étant réalisée dans la couche Si.

Dans un mode de réalisation, le dispositif est réalisé à partir d'une hétérostructure Ge/SiGe, la couche active étant réalisée dans la couche Ge.

Dans un mode de réalisation, le dispositif comprend des espaceurs disposés de sorte à séparer chaque premières grilles, deuxièmes grilles et troisièmes grilles des premières grilles, deuxièmes grilles et troisièmes grilles adjacentes.

Dans un mode de réalisation, le dispositif comprend avantageusement des espaceurs disposés de sorte à :
- séparer chaque première grille des premières, deuxièmes et troisièmes grilles adjacentes ;
- séparer chaque deuxième grille des premières, deuxièmes et troisièmes grilles adjacentes ; et
- séparer chaque troisième grille des premières, deuxièmes et troisièmes grilles adjacentes.

Dans un mode de réalisation, chaque première grille, deuxième grille et troisième grille comprend une électrode de grille et un oxyde de grille, et le matériau de l'électrode et de l'oxyde de grille des premières grilles, des deuxièmes grilles et des troisièmes grilles sont identiques.

Dans un mode de réalisation, l'oxyde des premières, deuxièmes et/ou troisièmes grilles est choisi parmi le SiO₂, le HfO₂ ou bien l'Al₂O₃.

Dans un mode de réalisation, l'épaisseur de l'oxyde des premières grilles, deuxièmes grilles et/ou troisièmes grilles est comprise entre 5 nm et 10 nm.

Dans un mode de réalisation, les électrodes des premières grilles, deuxièmes grilles et/ou troisièmes grilles sont réalisées dans un matériau conducteur choisi parmi le Ti, le TiN, du poly-Si ou bien encore le W.

Un deuxième aspect de l'invention concerne un procédé de fabrication d'un dispositif semi-conducteur à partir d'un substrat comportant une couche semi-conductrice, dite couche active, au niveau d'une première surface dudit substrat (c'est-à-dire sur une première surface dudit substrat ou proche de la première surface dudit substrat), le procédé comprenant :
- Une étape de dépôt d'une première couche diélectrique sur la première surface ;
- Une étape de dépôt d'une couche support sur la première couche diélectrique ;
- Une étape de gravure de la couche support de sorte à former une matrice de premiers piliers formant une pluralité de lignes et une pluralité de colonnes ;
- Une étape de dépôt conforme d'une deuxième couche diélectrique sur la matrice de premiers piliers, l'épaisseur déposée étant choisie de sorte à combler l'espace entre chaque premier pilier et ses plus proches voisins ;
- Une étape de gravure de la deuxième couche diélectrique de sorte à exposer la première couche diélectrique entre chaque premier pilier de la matrice de premiers piliers selon les diagonales de ladite matrice de premiers piliers ;
- Une étape de dépôt d'une première couche conductrice de sorte à combler les ouvertures réalisées lors de l'étape de gravure de la deuxième couche diélectrique ;
- une étape de polissage mécano-chimique de la structure obtenue à l'issue de l'étape précédente de sorte à obtenir une matrice de deuxièmes piliers conducteurs au niveau des ouvertures réalisées lors de l'étape de gravure de la deuxième couche diélectrique, l'arrêt du polissage se faisant sur la couche support de sorte que les deuxièmes piliers conducteurs ne sont plus en contact entre eux à l'issue de cette étape et forment les troisièmes grilles ;
- Une étape de retrait sélectif de la deuxième couche diélectrique de sorte à ne conserver sur la première couche diélectrique que la matrice de premiers piliers et la matrice de deuxièmes piliers ;
- Une étape de dépôt conforme d'une troisième couche diélectrique sur la matrice de premiers piliers et la matrice de deuxièmes piliers, l'épaisseur déposée étant choisie de sorte à combler l'espace entre chaque premier pilier et les deuxièmes piliers plus proches voisins dudit premier pilier ;
- Une étape de gravure de la troisième couche diélectrique de sorte à exposer la première couche diélectrique entre chaque premier pilier de la matrice de premiers piliers selon les lignes et les colonnes de ladite matrice de premiers piliers ;
- Une étape de dépôt d'une deuxième couche conductrice de sorte à combler les ouvertures réalisées lors de l'étape de gravure de la troisième couche diélectrique ;
- une étape de polissage mécano-chimique de la structure obtenue à l'issue de l'étape précédente, de sorte à obtenir une matrice de troisièmes piliers conducteur au niveau des ouvertures réalisées lors de l'étape de gravure de la troisième couche diélectrique, l'arrêt du polissage se faisant sur la couche support de sorte que les troisièmes piliers conducteurs ne sont plus en contact entre eux à l'issue de cette étape et forment les premières grilles et les deuxièmes grilles ;
- Une étape de retrait sélectif des premiers piliers de la pluralité de premiers piliers de sorte à exposer la première couche diélectrique au niveau de l'emplacement desdits premiers piliers ;
- Une étape de gravure sélective de la première couche diélectrique et de la couche active sur la totalité de leur épaisseur au niveau de l'emplacement desdits premiers piliers retirés lors de l'étape précédente de sorte à obtenir une pluralité d'ouvertures dans la couche active.

Grâce au procédé selon l'invention, il est possible d'obtenir un dispositif selon l'invention par auto-alignement en n'ayant recours qu'à un seul niveau de lithographie. Le procédé est ainsi grandement simplifié par rapport aux procédés de l'état de la technique dans lesquels plusieurs niveaux de lithographie (et donc pour lesquels un alignement précis est nécessaires) et/ou un écrantage partiel des grilles sont présents.

Outre les caractéristiques qui viennent d'être évoquées dans le paragraphe précédent, le procédé selon le deuxième aspect de l'invention peut présenter une ou plusieurs caractéristiques complémentaires parmi les suivantes, considérées individuellement ou selon toutes les combinaisons techniquement possibles.

Dans un mode de réalisation, le substrat est un substrat de type « silicium sur isolant » et la couche active est réalisée dans la couche de silicium du substrat située au-dessus de l'oxyde.

Dans un mode de réalisation, le matériau de la première couche diélectrique est choisi parmi le SiO₂, le HfO₂ ou bien encore l'Al₂O₃.

Dans un mode de réalisation, le matériau de la couche support est un matériau diélectrique.

Dans un mode de réalisation, la distance d séparant deux premiers piliers voisins et la hauteur h des premiers piliers à l'issue de l'étape de gravure de la couche support de sorte à former une matrice de premiers piliers sont choisis de sorte que h> d/2.

Dans un mode de réalisation, le procédé comprend, à l'issue de l'étape de gravure de la deuxième couche diélectrique, une étape de polissage mécano-chimique de la structure obtenue à l'issue de l'étape précédente.

Dans un mode de réalisation, le procédé comprend, avant l'étape de gravure de la troisième couche diélectrique, une étape de polissage mécano-chimique de la structure obtenue à l'issue de l'étape précédente.

Dans un mode de réalisation, le procédé comprend, après l'étape de polissage mécano-chimique de la structure obtenue à l'issue de l'étape de dépôt d'une deuxième couche conductrice, une étape de sur polissage mécano-chimique de la structure obtenue à l'issue de l'étape de polissage mécano-chimique précédente.

Dans un mode de réalisation, le procédé comprend, à l'issue de l'étape de gravure sélective de la première couche diélectrique et de la couche active, une étape de dépôt d'une quatrième couche diélectrique suivie d'une étape de polissage mécano-chimique de ladite couche, l'arrêt du polissage se faisant sur les deuxièmes et troisièmes piliers.

L'invention et ses différentes applications seront mieux comprises à la lecture de la description qui suit et à l'examen des figures qui l'accompagnent.

### BRÈVE DESCRIPTION DES FIGURES

Les figures sont présentées à titre indicatif et nullement limitatif de l'invention.
La [Fig. 1] montre une représentation schématique d'un dispositif selon l'invention.
Les [Fig. 2A] à [Fig. 2C] montrent une représentation schématique de différents substrats susceptibles d'être utilisés dans un dispositif ou un procédé selon l'invention.
La [Fig. 3] montre une représentation schématique d'un substrat de type SOI utilisé dans un procédé selon l'invention et servant dans les illustrations des différentes étapes du procédé.
La [Fig. 4A] à la [Fig. 4K] montrent une représentation schématique des étapes du procédé selon l'invention (la ou les étapes associées à chaque figure sont notées entre parenthèses).

### DESCRIPTION DÉTAILLÉE

Sauf précision contraire, un même élément apparaissant sur des figures différentes présente une référence unique.

### Dispositif quantique destiné à former une matrice de boites quantiques

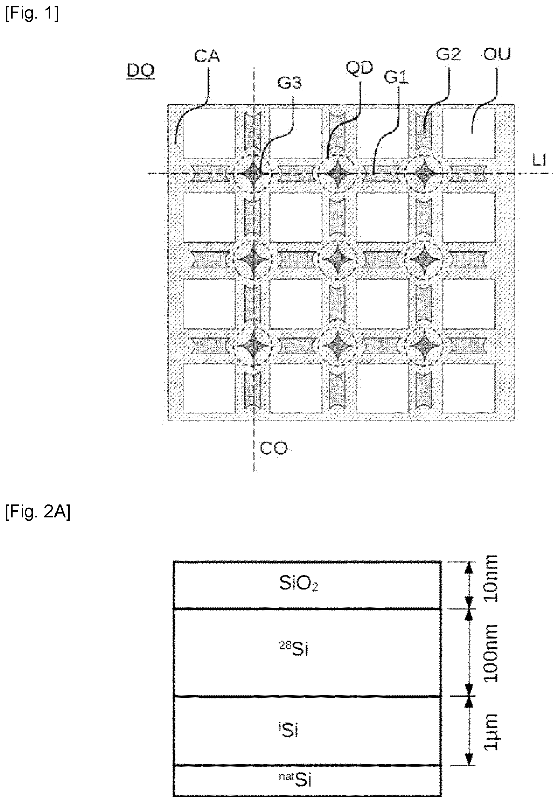

Un premier aspect de l'invention illustré à la [Fig. 1] concerne un dispositif quantique DQ configuré pour former une matrice de boites quantiques QD. Pour cela, le dispositif DQ comprend une couche active CA réalisée dans un matériau semi-conducteur. De préférence, cette couche CA est une couche de silicium (Si) ou de germanium (Ge), mais d'autres matériaux semi-conducteurs peuvent être envisagés. C'est dans cette couche active CA que seront formées les boites quantiques QD. Pour mémoire, une boite quantique QD est formée par un puits de potentiel électrostatique dans lequel il est possible de piéger une ou plusieurs particules chargées, par exemple un ou plusieurs trous ou un ou plusieurs électrons.

Le dispositif QD selon l'invention comprend également une pluralité de premières grilles G1 disposées selon une pluralité de lignes LI, au-dessus de la couche active CA. Le dispositif selon l'invention comprend également une pluralité de deuxièmes grilles G2 disposées selon une pluralité de colonnes CO perpendiculaires aux lignes LI de la pluralité de lignes LI, au-dessus de la couche active CA. Le dispositif DQ selon l'invention comprend en outre une pluralité de troisièmes grilles G3, chaque troisième grille G3 de la pluralité de troisièmes grilles G3 étant disposée à l'intersection d'une ligne LI de la pluralité de lignes LI et d'une colonne CO de la pluralité de colonnes CO, au-dessus de la couche active CA, chaque troisième grille G3 étant séparée des troisièmes grilles G3 les plus proches, sur une ligne LI par une première grille G1 et sur une colonne CO par une deuxième grille G2. Enfin, dans le dispositif DQ selon l'invention, la couche active CA comprend des ouvertures OU sur toute l'épaisseur de la couche active CA, lesdites ouvertures étant disposées entre les lignes LI de la pluralité de lignes LI et les colonnes CO de la pluralité de colonnes CO (ainsi les ouvertures OU forment également une matrice décalée par rapport à la matrice de boites quantiques QD).

Les premières grilles G1 sont séparées les unes des autres. Elles sont également séparées des deuxièmes et troisièmes grilles. Ainsi, chaque première grille G1 est polarisable indépendamment des autres grilles. Ceci permet d'appliquer un potentiel électrique sur chaque première grille sans polariser dans le même temps les premières, deuxièmes et/ou troisièmes grilles adjacentes. Les premières grilles sont ainsi polarisable indépendamment des grilles adjacentes.

De la même manière les deuxièmes grilles sont séparées les unes des autres et séparées des premières et troisièmes grilles de manière à être polarisables indépendamment des autres grilles. De la même manière les troisièmes grilles sont séparées les unes des autres et séparées des premières et deuxièmes grilles de manière à être polarisables indépendamment des autres grilles.

Ainsi, dans le dispositif DQ selon l'invention, une boite quantique QD pourra être formée au-dessous de chaque troisième grille G3 de sorte à former une matrice de boites quantiques QD. En effet, chaque première grille G1 de la pluralité de premières grilles G1 permet, lorsqu'on lui applique un potentiel électrique, de modifier la barrière de potentiel séparant deux parties de la couche active CA situées sous deux troisièmes grilles G3 adjacentes selon les lignes. De même, chaque deuxième grille G2 de la pluralité de deuxièmes grilles G2 permet, lorsqu'on lui applique un potentiel électrique, de modifier la barrière de potentiel séparant deux parties de la couche active CA situées sous deux troisièmes grilles G3 adjacentes selon les colonnes CO. De plus, les première grilles G1 et les deuxièmes grilles G2 permettent d'effectuer cette modification de manière locale, ces dernières G1, G2 étant au-dessus de la couche active CA (autrement dit, il n'y a pas de couche conductrice entre l'oxyde des première grilles G1 et des deuxièmes grilles G2 et la couche active CA). Aussi, grâce au contrôle des barrières de potentiel exercé par les première grilles G1 et les deuxième grilles G2, il est possible de réaliser un confinement électrostatique des particules chargées au-dessous des troisièmes grilles G3 de la pluralité de troisièmes grilles G3 pour former une boite quantique QD sous chaque troisième grille G3. Ce confinement électrostatique est en outre complété par un confinement structurel obtenu grâce aux ouvertures OU présentes dans la couche active, puisqu'aucune particule chargée ne peut se trouver au niveau desdites ouvertures OU.

Par ailleurs, dans chaque boite quantique QD, le ou les particules chargées présentes sont associées à un potentiel chimique. Or, chaque troisième grille G3 étant au-dessus de la partie de la couche active CA dans laquelle est formée une boite quantique (autrement dit, il n'y a pas de couche conductrice entre l'oxyde des troisièmes grilles G3 et la couche active CA), chaque troisième grille G3 de la pluralité de troisièmes grilles G3 permet, lorsqu'on lui applique un potentiel électrique, de modifier le potentiel chimique des particules chargées présentes dans boite quantique QD associée à la troisième grille G3 considérée.

Dans le mode de réalisation de la [Fig. 1], le dispositif comprend une unique couche active CA présentant des ouvertures et formant des bandes s'étendant selon des lignes LI et des colonnes CO. L'intégralité des premières, deuxièmes et troisièmes grilles G1, G2, G3 s'étendent entièrement au-dessus de la couche active CA. Aucune grille ne s'étend qu'en partie au-dessus de la couche active CA. En d'autres termes, la couche active CA s'étend sous chaque première, deuxième et troisième grille G1, G2, G3. En particulier, dans l'exemple illustré, la couche active CA s'étend même au-delà de chaque grille G1, G2, G3 précitée.

Les premières, deuxièmes et troisièmes grilles G1, G2, G3 forment par exemple un ensemble s'étendant sur la couche active CA. Ledit ensemble présente par exemple une première dimension, pouvant être mesurée suivant une ligne des lignes LI de la pluralité de lignes LI ou une colonne CO de la pluralité de colonnes CO. La couche active CA présente une deuxième dimension, mesurée suivant la même ligne ou la même colonne. La deuxième dimension est alors au moins égale à la deuxième dimension, de sorte que chaque grille G1, G2, G3 s'étend sur la couche active CA. Préférentiellement, la deuxième dimension est supérieure à la première dimension de sorte que les grilles G1, G2, G3 puissent être éloignées des bords de la couche CA.

Dans le mode de réalisation de la [Fig. 1], chaque première grille G1 et chaque deuxième grille G2 présente une forme rectangulaire. Chaque grille G1, G2 présente ainsi une longueur et une largeur, mesurées dans le plan (c'est-à-dire parallèlement à la couche active CA), sa largeur étant mesurée perpendiculairement à sa longueur, sa longueur étant supérieure ou égale à sa largeur. Chaque première grille G1 est disposée de sorte que sa longueur soit alignée parallèlement aux lignes LI. Chaque deuxième grille G2 est disposée de sorte que sa longueur soit alignée parallèlement aux colonnes CO. Cet alignement particulier peut être le résultat du procédé de fabrication selon l'invention, détaillé ci-après.

Les premières et deuxièmes grilles G1, G2 peuvent également présenter une épaisseur, mesurée perpendiculairement au plan. Pour chaque grille G1, G2, son épaisseur est avantageusement inférieure à sa longueur.

Dans la [Fig. 1], chaque troisième grille G3 présente une forme d'étoile à quatre branches. Chacune des branches est alignée selon une ligne LI ou une colonne CO. Autrement dit, chaque troisième grille G3 présente une première diagonale, passant par deux des branches opposées, parallèle à la ligne LI sur laquelle se trouve ladite grille G3. Chaque troisième grille G3 présente également une deuxième diagonale distincte de la première diagonale, passant par deux autres des branches opposées, parallèle à la colonne CO sur laquelle se trouve ladite grille G3. La forme et l'orientation de cette forme pour les troisièmes grilles G3 peut être le résultat sur procédé de fabrication mis en oeuvre.

Ainsi, chaque première ou deuxième grille G1, G2, adjacente d'une troisième grille G3, a sa longueur qui est alignée selon l'une des branches de ladite troisième grille G3.

De manière plus précise, les premières et deuxièmes grilles G1, G2 peuvent présenter des pointes, du fait de leur forme rectangulaire. Chacune des premières et deuxièmes grilles G1, G2 peut présenter une troisième diagonale, passant par deux des sommets opposés de ladite grille. Cette troisième diagonale présente avantageusement un angle avec l'une ligne LI qui est inférieur ou égal à 45°. Autrement dit, la troisième diagonale d'une première ou deuxième grille G1, G2, présente un angle avec l'une des deux diagonales d'une troisième grille adjacente G3, qui est inférieur ou égal à 45°.

Les premières, deuxièmes et troisièmes grilles G1, G2, G3 présentent avantageusement une même distance, à 10 % près, avec la couche active CA. Ceci permet d'obtenir un couplage grille/couche active sensiblement identique. Les premières, deuxièmes et troisièmes grilles G1, G2, G3 sont par exemple séparées de la couche active CA par une couche diélectrique.

Dans un mode de réalisation, l'oxyde des premières G1, deuxièmes G2 et/ou troisièmes grilles G3 est choisi parmi le SiO₂, le HfO₂ ou bien l'Al₂O₃. Dans un mode de réalisation, l'épaisseur de l'oxyde des premières grilles G1, deuxièmes grilles G2 et/ou troisièmes grilles G3 est comprise entre 5 nm et 10 nm. Dans un mode de réalisation, les électrodes des premières grilles G1, deuxièmes grilles G2 et/ou troisièmes grilles G3 sont réalisées dans un matériau conducteur choisi parmi le Ti, le TiN ou bien encore le W.

Dans un mode de réalisation, le dispositif selon l'invention est réalisé dans un substrat de type SOI et la couche active est une couche de silicium. Dans ce mode de réalisation, les premières, deuxièmes et troisièmes grilles G1, G2, G3 sont au contact direct de la couche active CA.

Dans un mode de réalisation alternatif, le dispositif est réalisé à partir d'un substrat de silicium massif. Avantageusement, le substrat comprend une couche de silicium épitaxiée (notée ²⁸Si sur la figure) recouverte par un oxyde thermique (noté SiO₂ sur la figure), cette couche de silicium épitaxiée étant déposée sur la couche de silicium intrinsèque (noté ⁱSi sur la figure) du substrat de silicium massif. Un tel substrat est illustré à la [Fig. 2A]. Dans ce mode de réalisation, la couche active CA est réalisée dans la couche de silicium, avantageusement la couche de silicium epitaxiée. Les dimensions indiquées sur la figure sont bien entendu données à titre purement illustratif.

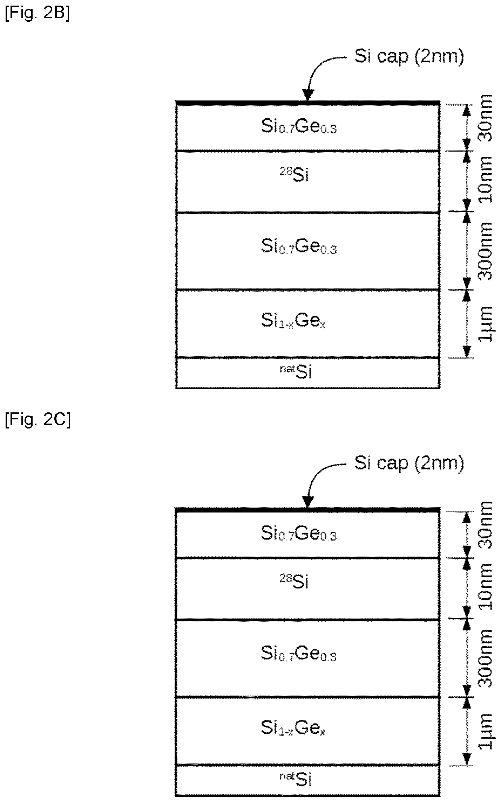

Dans un mode de réalisation alternatif, le dispositif est réalisé à partir d'une hétérostructure Si/SiGe. Un substrat comprenant une telle hétérostructure est illustré à la [Fig. 2B]. Cette dernière comprend une couche dont la concentration en Ge évolue de manière linéaire (notée Si₁₋ₓGeₓ sur la figure) sur laquelle repose une couche de SiGe (notée Si_{0.7}Ge_{0.3}), un puit quantique destiné aux électrons formé dans une couche de Si (notée ²⁸Si sur la figure), un espaceur en SiGe (noté Si_{0.7}Ge_{0.3} sur la figure) situé sur la couche de Si et une couche de silicium (notée Si Cap sur la figure). Dans ce mode de réalisation, la couche active est réalisée dans la couche Si. Les dimensions indiquées sur la figure sont bien entendu données à titre purement illustratif.

Dans un mode de réalisation alternatif, le dispositif est réalisé à partir d'une hétérostructure Ge/SiGe. Un substrat comprenant une telle hétérostructure est illustré à la [Fig. 2C]. Cette dernière comprend une couche dont la concentration en Si évolue de manière linéaire (notée Si₁₋ₓGeₓ sur la figure) sur laquelle repose une couche de SiGe (notée Si_{0.2}Ge_{0.8}), un puit quantique destiné aux trous formé dans une couche de Ge (notée Ge sur la figure), un espaceur en SiGe (noté Si_{0.2}Ge_{0.8} sur la figure) situé sur la couche de Ge et une couche de silicium (noté Si Cap sur la figure). Dans ce mode de réalisation, la couche active est réalisée dans la couche Ge. Les dimensions indiquées sur la figure sont bien entendu données à titre purement illustratif.

### Procédé de fabrication d'un dispositif quantique comportant une matrice d'îlots

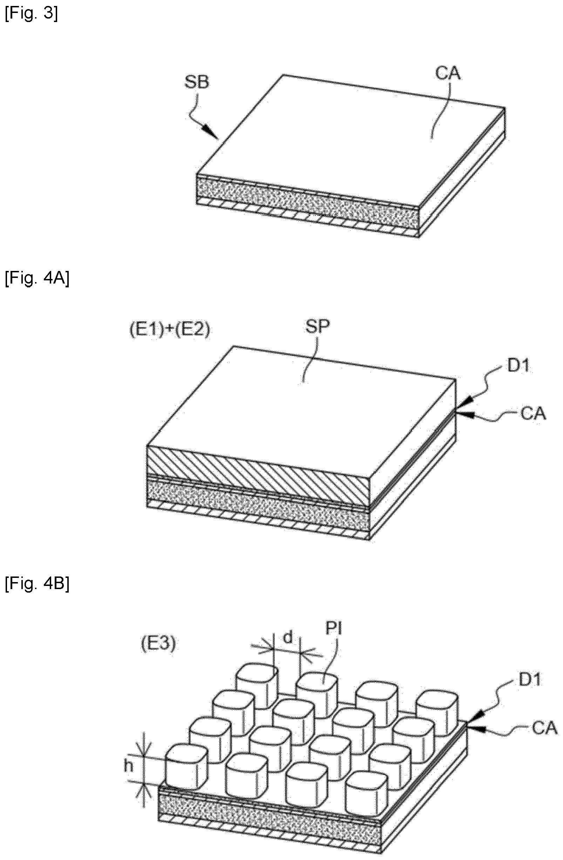

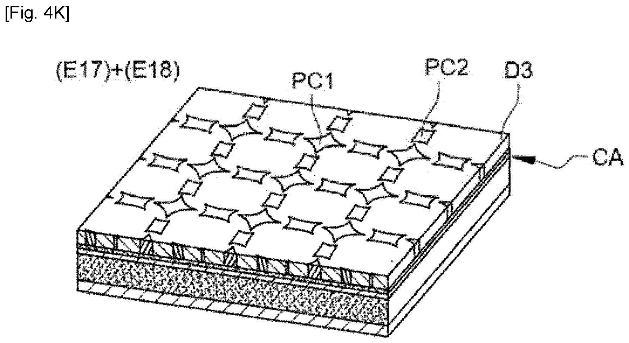

Un deuxième aspect de l'invention illustré aux [Fig. 3] à [Fig. 4K] concerne un procédé de fabrication d'un dispositif semi-conducteur selon l'invention à partir d'un substrat SB comportant une couche semi-conductrice, dite couche active CA, sur une première surface dudit substrat SB ou proche de la première surface. On entend par proche de la première surface que la distance séparant la couche active de la première surface est inférieure à la distance séparant la couche active de la deuxième surface du substrat opposée à la première surface. De préférence la distance séparant la couche active CA de la première surface du substrat SB est inférieure à 500 nm, de préférence inférieure à 200 nm, voire inférieure à 100 nm. Dans un mode de réalisation, l'épaisseur de la couche active CA est comprise entre 5 et 20 nm, par exemple égale à 10 nm.

Dans un mode de réalisation, la couche active CA est en silicium, le substrat étant de préférence un substrat de type SOI (pour Silicon-On-Insulator en anglais). Dans un mode de réalisation alternatif, le substrat est un substrat de type SiMOS tel que décrit précédemment. Dans un mode de réalisation alternatif, le substrat comprend une hétérostructure Si/SiGe tel que décrite précédemment au niveau de sa première surface. Dans un mode de réalisation alternatif, le substrat comprend une hétérostructure Ge/SiGe tel que décrite précédemment au niveau de sa première surface.

Le procédé selon l'invention comprend une étape E1 de dépôt d'une première couche diélectrique D1 sur la première surface. Lorsque la couche active CA est au niveau de cette première surface (comme illustré aux [Fig.3] à [Fig. 4K], alors ce dépôt est effectué sur la couche active CA. Dans un mode de réalisation, le matériau de la première couche diélectrique D1 est choisi parmi le SiO₂, le HfO₂ ou bien encore l'Al₂O₃. Dans un mode de réalisation, la première couche diélectrique D1 est réalisée dans un matériau diélectrique à haute permittivité. Dans un mode de réalisation, le première couche diélectrique D1 comporte plusieurs sous-couches diélectriques. Par exemple, elle comporte une première sous-couche de SiO₂ assurant une bonne qualité d'interface avec la couche sur laquelle elle est déposée (par exemple la couche active de Si), puis une deuxième sous-couche de HfO₂ ou d'Al₂O₃. Il ne s'agit bien entendu que d'un exemple et d'autres combinaisons peuvent être envisagées.

Le procédé comprend ensuite une étape E2 de dépôt d'une couche support SP sur la première couche diélectrique D1. Dans un mode de réalisation, le matériau de la couche support SP est un matériau diélectrique, par exemple du nitrure de silicium.

Comme illustré à la [Fig. 4B], le procédé comprend ensuite une étape E3 de gravure de la couche support de sorte à former une matrice de premiers piliers PI formant une pluralité de lignes et une pluralité de colonnes. De préférence, la distance d séparant deux premiers piliers PI voisins et la hauteur h des premiers piliers PI sont choisis de sorte que h > d/2. De préférence, la hauteur h des premiers piliers est comprise entre 50 nm et 500 nm, par exemple égale à 200 nm.

Le procédé comprend également une étape E4 de dépôt conforme d'une deuxième couche diélectrique D2 sur la matrice de premiers piliers PI, l'épaisseur déposée étant choisie de sorte à combler l'espace entre chaque premier pilier PI et ses plus proches voisins. Dans un mode de réalisation, la couche diélectrique D2 est en SiO₂. Dans un mode de réalisation, le deuxième couche diélectrique D2 comporte plusieurs sous-couches diélectriques.

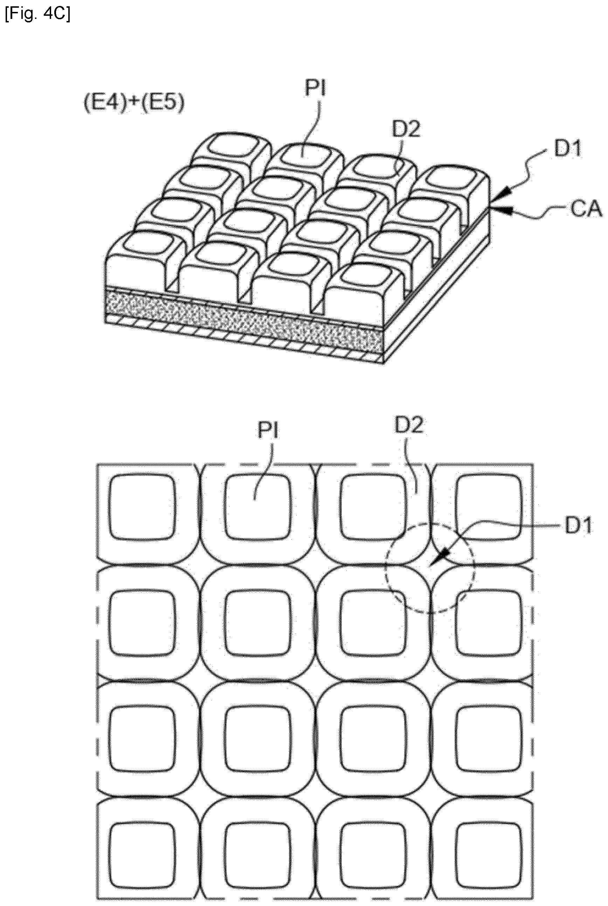

Le procédé comprend ensuite une étape E5 de gravure de la deuxième couche diélectrique D2 de sorte à exposer la première couche diélectrique D1 entre chaque premier pilier PI de la matrice de premiers piliers PI selon les diagonales de ladite matrice de premier piliers PI, la première couche diélectrique D1 servant de couche d'arrêt à la gravure. Dans un exemple de réalisation, la deuxième couche diélectrique D2 est une couche de SiO₂ et la première couche diélectrique D1 (servant de couche d'arrêt) est une couche de HfO₂ ou d'Al₂O₃. La structure obtenue à l'issue de ces deux étapes est illustrée à la [Fig. 4C], les zones exposées de la première couche diélectrique D1 étant marquées par un cercle en pointillé dans la représentation de dessus en bas de la figure.

Dans un mode de réalisation, le procédé comprend également une étape E6 de polissage mécano-chimique de la structure obtenue à l'issue de l'étape E5 précédente. Bien que facultative, cette étape E6 permet d'aplanir la surface de la structure et ainsi d'améliorer la qualité du dépôt de la couche conductrice C1 décrit dans la suite. En outre, réaliser le polissage mécano-chimique en deux temps permet d'éviter tout problème de sélectivité avec le polissage mécano-chimique effectué à l'issue du dépôt de la couche conductrice C1 décrit dans la suite.

Le procédé selon l'invention comprend ensuite une étape E7 de dépôt d'une première couche conductrice C1 de sorte à combler les ouvertures réalisées lors de l'étape E5 de gravure de la deuxième couche diélectrique D2. Ainsi, au niveau de ces ouvertures, la couche conductrice C1 est en contact direct avec la première couche diélectrique D1. Dans un mode de réalisation, le matériau de la couche conductrice C1 est choisi parmi le Ti, TiN ou bien encore W.

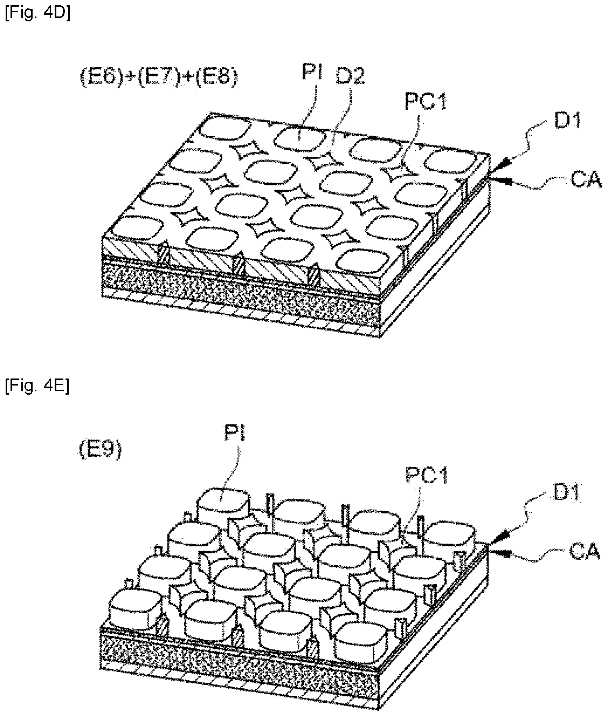

Le procédé selon l'invention comprend en outre une étape E8 de polissage mécano-chimique de la structure obtenue à l'issue de l'étape E7 précédente de sorte à obtenir une matrice de deuxièmes piliers PC1 conducteurs au niveau des ouvertures réalisées lors de l'étape E5 de gravure de la deuxième couche diélectrique D2. Lors de cette étape E8, l'arrêt du polissage se fait sur la couche support SP de sorte que les deuxième piliers PC1 ne sont plus en contact entre eux à l'issue de cette étape E8. La structure obtenue à l'issue de ces deux étapes ou trois étapes (lorsque l'étape E6 facultative de polissage mécano-chimique est mise en oeuvre) est illustrée à la [Fig. 4D]. Dans la structure finale obtenue à l'issue du procédé selon l'invention, les deuxièmes piliers PC1 conducteurs viendront former les troisièmes grilles G3 de la [Fig. 1] permettant de contrôler le potentiel chimique des particules chargées au niveau des boites quantiques QD.

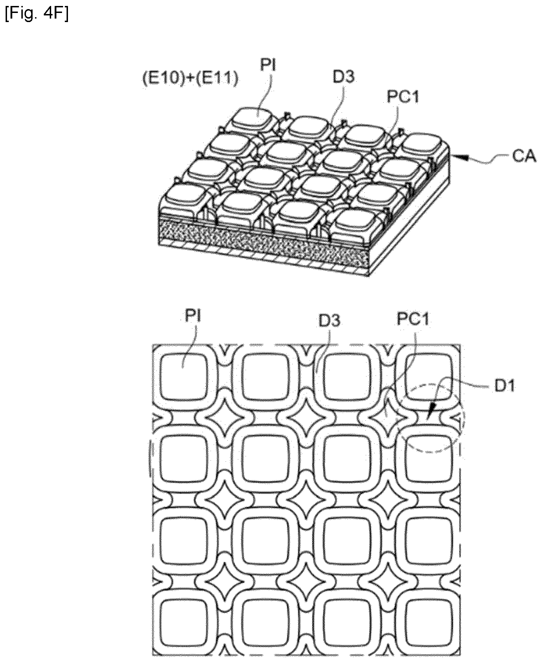

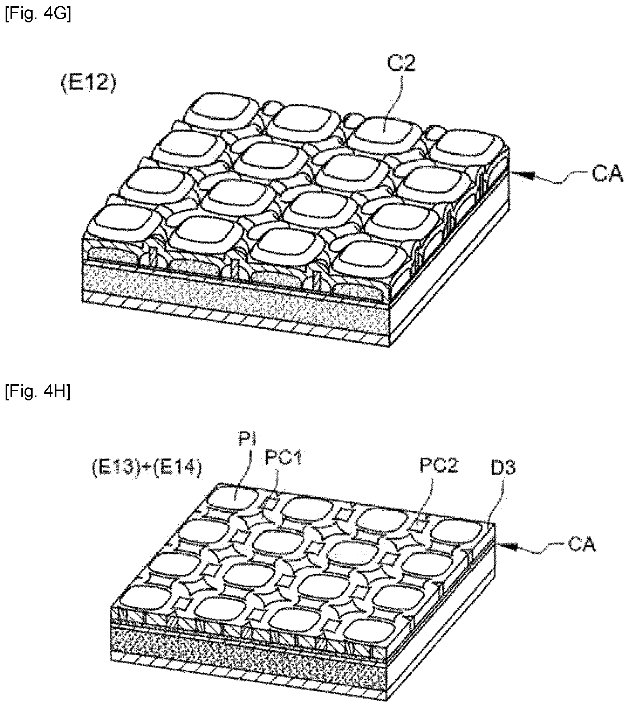

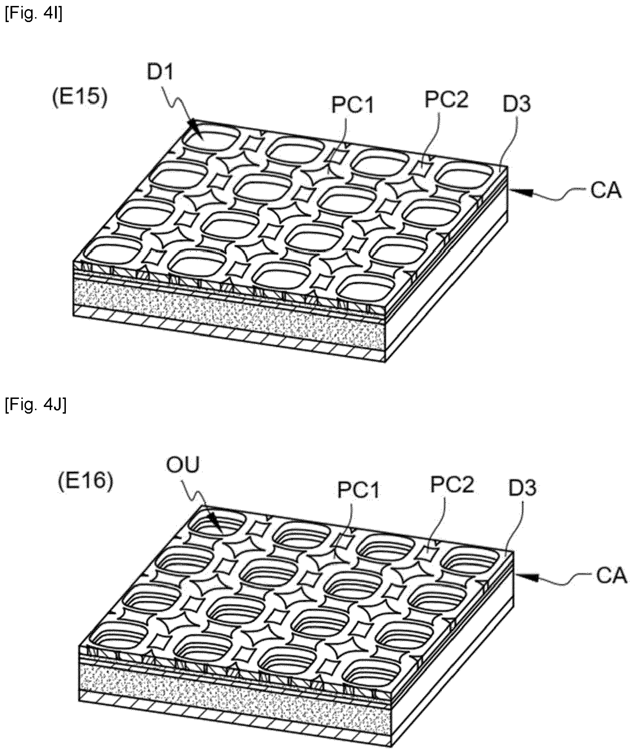

Comme illustré à la [Fig. 4^{E}], le procédé comprend ensuite une étape E9 de retrait sélectif de la deuxième couche diélectrique D2 de sorte à ne conserver sur la première couche diélectrique (D1) que la matrice de premiers piliers PI et la matrice de deuxièmes piliers PC1. Lors de cette étape de retrait, la première couche diélectrique D1 est préservée et sert de couche d'arrêt.

Le procédé comprend ensuite une étape E10 de dépôt conforme d'une troisième couche diélectrique D3 sur la matrice de premiers piliers PI et sur la matrice de deuxièmes piliers PC1, l'épaisseur déposée étant choisie de sorte à combler l'espace entre chaque premier pilier PI et les deuxièmes piliers PC2 plus proches voisins dudit premier pilier PI.

Le procédé comprend également une étape E11 de gravure de la troisième couche diélectrique D3 de sorte à exposer la première couche diélectrique D1 entre chaque premier pilier PI de la matrice de premiers piliers PI selon les lignes et les colonnes de ladite matrice de premiers piliers PI. La structure obtenue à l'issue de ces deux étapes est illustrée à la [Fig. 4F], les zones exposées de la première couche diélectrique D1 étant marquées par un cercle en pointillé.

Dans un mode de réalisation, le procédé comprend une étape de polissage mécano-chimique de la structure obtenue à l'issue de l'étape E11 précédente (non représentée sur les figures). Bien que facultative, cette étape permet d'aplanir la surface de la structure et ainsi d'améliorer la qualité du dépôt de la couche conductrice C2 décrit dans la suite. En outre, réaliser le polissage mécano-chimique en deux temps permet d'éviter tout problème de sélectivité avec le polissage mécano-chimique effectué à l'issue du dépôt de la couche conductrice C2 décrit dans la suite.

Comme illustré à la [Fig. 4G], le procédé comprend ensuite une étape E12 de dépôt d'une deuxième couche conductrice C2 de sorte à combler les ouvertures réalisées lors de l'étape E11 de gravure de la troisième couche diélectrique D3. Ainsi, au niveau de ces ouvertures, la deuxième couche conductrice C2 est en contact direct avec la première couche diélectrique D1. Dans un mode de réalisation, le matériau de la deuxième couche conductrice C2 est choisi parmi le Ti, TiN ou bien encore W.

Il résulte du procédé que chaque première, deuxième et troisième grilles G1, G2, G3 s'étend contre la première couche diélectrique D1. Cette dernière est également commune à toutes les grilles G1, G2, G3.

Le procédé comprend ensuite une étape E13 de polissage mécano-chimique de la structure obtenue à l'issue de l'étape précédente, de sorte à obtenir une matrice de troisièmes piliers PC2 conducteurs, lesdits troisièmes piliers PC2 conducteurs étant en contact direct avec la première couche diélectrique D1 au niveau des ouvertures réalisées lors de l'étape E11 de gravure de la troisième couche diélectrique D3. Lors de cette étape E13, l'arrêt du polissage se fait sur la couche support SP de sorte que les troisième piliers PC2 ne sont plus connectés entre eux à l'issue de cette étape E13. Dans un mode de réalisation, afin de s'assurer de la bonne déconnexion des troisièmes piliers entre eux, une étape E14 de sur polissage mécano-chimique de la structure obtenue à l'issue de l'étape E13 est mise en oeuvre. On entend par « sur polissage » le fait de continuer le polissage alors que la couche d'arrêt a été atteinte. En effet, la détection de l'atteinte des couches d'arrêt par le polissage se fait de façon automatique par détection physique d'un signal de polissage de la couche d'arrêt. Or, s'il existe des non-uniformités d'épaisseur à l'échelle de la plaque, il se peut que le signal soit détecté alors que la couche d'arrêt n'a pas été atteinte sur l'ensemble de la plaque, mais seulement sur une partie. Le « sur polissage » permet donc de poursuivre le polissage suffisamment longtemps après que le signal a été détecté de sorte que toutes les zones de la plaque soient polies suffisamment. La structure obtenue à l'issue de cette étape E13 ou de ces deux étapes (lorsque l'étape E14 facultative de sur polissage est mise en oeuvre) est illustré à la [Fig. 4H]. Dans la structure finale, les troisième piliers PC2 conducteurs viendront former les premières grilles G1 et les deuxièmes grilles G2 de la [Fig. 1] permettant de contrôler la barrière de potentiel entre deux boites quantiques QD adjacentes.

Comme illustré à la [Fig. 4I], le procédé comprend ensuite une étape E15 de retrait sélectif des premiers piliers PI de la pluralité de premiers pilier PI de sorte à exposer la première couche diélectrique D1 au niveau de l'emplacement desdits premiers piliers PI. Lorsque le matériau des premiers piliers est un diélectrique, par exemple du SiN, cette étape de retrait peut être mise en oeuvre par un procédé de gravure humide sélective, par exemple à base de H₃PO₄.

Comme illustré à la [Fig. 4J], le procédé comprend également une étape E16 de gravure sélective (par rapport aux matériaux conducteurs des piliers conducteurs PC1, PC2) de la première couche diélectrique D1 et d'une partie du substrat comprenant la couche active CA sur la totalité de l'épaisseur de la coucha active CA au niveau de l'emplacement des premiers piliers PI retirés lors de l'étape E15 précédente de sorte à former des ouvertures OU dans la couche active CA.

Lorsque le substrat est de type SOI, alors la couche active de Si est gravée sur toute son épaisseur lors de cette étape E16. Lorsque le substrat est de type SiMOS, alors la couche de SiO₂ et la couche de Si (couche active) sont gravées sur toute leur épaisseur lors de cette étape E16. Lorsque le substrat comprend une hétérostructure Si/SiGe, alors la couche Si cap, l'espaceur en SiGe et la couche de Si (couche active CA) sont gravées sur toute leur épaisseur lors de cette étape E16. Lorsque le substrat comprend une hétérostructure Ge/SiGe, alors la couche Si cap, l'espaceur en SiGe et la couche de Ge (couche active CA) sont gravées sur toute leur épaisseur lors de cette étape E16.

En retirant la couche active CA (et les couches situées au-dessus lorsque cela est nécessaire), on s'assure que les particules chargées ne pourront pas se situées dans cette zone, ce qui facilite leur confinement au niveau des boites quantiques formées en-dessous des deuxièmes piliers PC1 conducteurs. Dans la structure finale, les ouvertures ainsi réalisées correspondent aux ouvertures OU de la [Fig. 1] permettant de s'assurer de l'absence de particule chargée entre les lignes LI et les colonnes CO.

Dans un mode de réalisation, le procédé comprend une étape E17 de dépôt d'une quatrième couche diélectrique suivie d'une étape E18 de polissage mécano-chimique de ladite couche, l'arrêt du polissage se faisant sur les deuxièmes et troisièmes piliers PC1, PC2. La structure obtenue à l'issue de ces deux étapes est illustrée à la [Fig. 4K].

Comme le montrent la [Fig. 1] et la [Fig. 4K], dans le dispositif ainsi obtenu, les troisièmes grilles G3 présentent de préférence une symétrie centrale et la répartition des premières grilles G1 et deuxièmes grilles G2 adjacentes à chaque troisième grille G3 se fait selon cette symétrie. De même, le premières, deuxièmes et troisièmes grilles G1,G2,G3 sont préférentiellement réparties de manière symétrique par rapport à l'axe associé à chaque ligne LI et l'axe associé à chaque colonne CO.

## Revendications

1. Dispositif quantique (DQ) configuré pour former une matrice de boites quantiques (QD), le dispositif (DQ) comprenant :
- Une couche active (CA) réalisée dans un matériau semi-conducteur ;
- Une pluralité de premières grilles (G1) disposées selon une pluralité de lignes (LI), chaque première grille de la pluralité de premières grilles s'étendant entièrement sur la couche active (CA) ;
- Une pluralité de deuxièmes grilles (G2) disposées selon une pluralité de colonnes (CO) perpendiculaires aux lignes (LI) de la pluralité de lignes (LI), chaque deuxième grille de la pluralité de deuxièmes grilles s'étendant entièrement sur la couche active (CA) ;
- Une pluralité de troisièmes grilles (G3), chaque troisième grille (G3) de la pluralité de troisièmes grilles (G3) étant disposée à l'intersection d'une ligne de la pluralité de lignes (LI) et d'une colonne de la pluralité de colonnes (CO), chaque troisième grille (G3) étant séparée des troisièmes grilles (G3) les plus proches, sur une ligne (LI) par une première grille (G1) et sur une colonne (CO) par une deuxième grille (G2) ;
la couche active (CA) comprenant des ouvertures (OU) sur toute l'épaisseur de la couche active (CA) disposées entre les lignes (LI) de la pluralité de lignes (LI) et les colonnes (CO) de la pluralité de colonnes (CO).

2. Dispositif (DQ) selon la revendication précédente **caractérisé en ce que** chaque troisième grille (G3) de la pluralité de troisièmes grilles (G3) s'étend entièrement sur la couche active (CA).

3. Dispositif (DQ) selon la revendication précédente caractérisé en ce chaque grille des pluralités de premières, deuxièmes et troisièmes grilles (G1, G2, G3), s'étend sur une première dimension, dite première largeur, mesurée selon une ligne ou une colonne, la couche active (CA) présentant une deuxième dimension, dite deuxième largeur, mesurée selon ladite ligne ou ladite colonne, supérieure ou égale à la première largeur.

4. Dispositif (DQ) selon l'une des revendications précédentes **caractérisé en ce que** chaque première grille présente une longueur et une largeur, inférieure ou égale à la longueur, chaque première grille étant disposée de sorte que sa longueur soit alignée avec une ligne de la pluralité de lignes ; et **en ce que** chaque deuxième grille présente une longueur et une largeur, inférieure ou égale à la longueur, chaque deuxième grille étant disposée de sorte que sa longueur soit alignée avec une colonne de la pluralité de colonne.

5. Dispositif (DQ) selon l'une des revendications précédentes **caractérisé en ce que** chaque troisième grille (G3) présente une forme d'étoile à quatre branches dont une première diagonale, passant par deux branches opposées, est parallèle à une ligne (LI) de la pluralité de lignes (LI), et dont une deuxième diagonale, distincte de la première diagonale et passant par deux autres branches opposées, est parallèle à une colonne (CO) de la pluralité de colonne (CO).

6. Dispositif (DQ) selon l'une des revendications précédentes **caractérisé en ce que** les premières, deuxièmes et troisièmes grilles (G1, G2, G3) sont disposées à une même distance de la couche active (CA).

7. Dispositif (DQ) selon l'une des revendications précédentes **caractérisé en ce qu'**il comprend une première couche diélectrique (D1) s'étendant sur la couche active (CA), chaque première grille (G1), chaque deuxième grille (G2) et chaque troisième grille (G3) s'étendant sur la première couche diélectrique, la première couche diélectrique étant commune à toutes les grilles.

8. Dispositif (DQ) selon l'une des revendications précédentes **caractérisé en ce que** la pluralité de premières grilles (G1) est polarisable indépendamment de la pluralité de troisièmes grilles (G3).

9. Dispositif (DQ) selon l'une des revendications précédentes **caractérisé en ce que** la pluralité de deuxièmes grilles (G2) est polarisable indépendamment de la pluralité de troisièmes grilles (G3).

10. Dispositif (DQ) selon l'une des revendications précédentes **caractérisé en ce que** chaque pluralité de grilles parmi les pluralités de premières, deuxièmes et troisièmes grilles (G1, G2, G3), est polarisable indépendamment des autres pluralités de grilles parmi les pluralités de premières, deuxièmes et troisièmes grilles (G1, G2, G3).

11. Dispositif (DQ) selon l'une des revendications précédentes **caractérisé en ce que** chaque grille parmi les premières, deuxièmes et troisièmes grilles (G1, G2, G3) est polarisable indépendamment des autres grilles parmi les premières, deuxièmes et troisièmes grilles (G1, G2, G3).

12. Dispositif selon l'une des revendications précédentes **caractérisé en ce que** la couche active (CA) est réalisée dans la couche Si d'une hétérostructure Si/SiGe.

13. Dispositif selon l'une des revendications précédentes comprenant des espaceurs disposés de sorte à :
- séparer chaque première grille (G1) des premières, deuxièmes et troisièmes grilles (G1, G2, G3) adjacentes ;
- séparer chaque deuxième grille (G2) des premières, deuxièmes et troisièmes grilles (G1, G2, G3) adjacentes ; et
- séparer chaque troisième grille (G3) des premières , deuxièmes et troisièmes grilles (G1, G2, G3) adjacentes.

14. Procédé de fabrication du dispositif quantique selon l'une des revendications précédentes à partir d'un substrat (SB) comportant une couche semi-conductrice, dite couche active (CA), au niveau d'une première surface dudit substrat (SB), le procédé comprenant :
- Une étape (E1) de dépôt d'une première couche diélectrique (D1) sur la première surface ;
- Une étape (E2) de dépôt d'une couche support (SP) sur la première couche diélectrique (D1) ;
- Une étape (E3) de gravure de la couche support (SP) de sorte à former une matrice de premiers piliers (PI) formant une pluralité de lignes et une pluralité de colonnes ;
- Une étape (E4) de dépôt conforme d'une deuxième couche diélectrique (D2) sur la matrice de premiers piliers (PI), l'épaisseur déposée étant choisie de sorte à combler l'espace entre chaque premier pilier (PI) et ses plus proches voisins ;
- Une étape (E5) de gravure de la deuxième couche diélectrique (D2) de sorte à exposer la première couche diélectrique (D1) entre chaque premier pilier (PI) de la matrice de premiers piliers (PI) selon les diagonales de ladite matrice de premier piliers (PI) ;
- Une étape (E7) de dépôt d'une première couche conductrice (C1) de sorte à combler les ouvertures réalisées lors de l'étape (E5) de gravure de la deuxième couche diélectrique (D2) ;
- une étape (E8) de polissage mécano-chimique de la structure obtenue à l'issue de l'étape précédente de sorte à obtenir une matrice de deuxièmes piliers (PC1) conducteurs (PC1) au niveau des ouvertures réalisées lors de l'étape (E5) de gravure de la deuxième couche diélectrique (D2), l'arrêt du polissage se faisant sur la couche support (SP) de sorte que les deuxièmes piliers (PC1) conducteurs ne sont plus en contact entre eux à l'issue de cette étape (E8) et forment les troisièmes grilles (G3) ;
- Une étape (E9) de retrait sélectif de la deuxième couche diélectrique (D2) de sorte à ne conserver sur la première couche diélectrique (D1) que la matrice de premiers piliers (PI) et la matrice de deuxièmes piliers (PC1) ;
- Une étape (E10) de dépôt conforme d'une troisième couche diélectrique (D3) sur la matrice de premier piliers (PI) et la matrice de deuxièmes piliers (PC1), l'épaisseur déposée étant choisie de sorte à combler l'espace entre chaque premier pilier (PI) et les deuxièmes piliers (PC2) plus proches voisins dudit premier pilier (PI) ;
- Une étape (E11) de gravure de la troisième couche diélectrique (D3) de sorte à exposer la première couche diélectrique (D1) entre chaque premier pilier (PI) de la matrice de premiers piliers (PI) selon les lignes et les colonnes de ladite matrice de premiers piliers (PI) ;
- Une étape (E12) de dépôt d'une deuxième couche conductrice (C2) de sorte à combler les ouvertures réalisées lors de l'étape (E11) de gravure de la troisième couche diélectrique (D3) ;
- une étape (E13) de polissage mécano-chimique de la structure obtenue à l'issue de l'étape précédente, de sorte à obtenir une matrice de troisièmes piliers (PC2) conducteur au niveau des ouvertures réalisées lors de l'étape (E11) de gravure de la troisième couche diélectrique (D3), l'arrêt du polissage se faisant sur la couche support (SP) de sorte que les troisièmes piliers (PC2) conducteurs ne sont plus en contact entre eux à l'issue de cette étape (E13) et forment les premières grilles (G1) et les deuxièmes grilles (G2) ;
- Une étape (E15) de retrait sélectif des premiers piliers (PI) de la pluralité de premiers piliers (PI) de sorte à exposer la première couche diélectrique (D1) au niveau de l'emplacement desdits premiers piliers (PI) ;
- Une étape (E16) de gravure sélective de la première couche diélectrique (D1) et de la couche active (CA) sur la totalité de leur épaisseur au niveau de l'emplacement desdits premiers piliers (PI) retirés lors de l'étape (E15) précédente de sorte à obtenir une pluralité d'ouvertures (OU) dans la couche active (CA).

15. Procédé selon la revendication précédente dans lequel le substrat (SB) est un substrat de type « silicium sur isolant » et la couche active (CA) est réalisée dans la couche de silicium du substrat (SB).

16. Procédé selon l'une des deux revendications précédentes dans lequel la distance d séparant deux premiers piliers (PI) voisins et la hauteur h des premiers piliers (PI) à l'issue de l'étape (E3) de gravure de la couche support (SP) de sorte à former une matrice de premiers piliers (PI) sont choisis de sorte que h > d/2.
